# EUROPEAN PATENT APPLICATION

(11) **EP 3 461 146 A1**
(43) Date of publication of application: **27.03.2019**
(21) Application number: 17192190.1
(22) Date of filing: 20.09.2017
(51) Int. Cl.: H04R 3/00, H03G 3/32

(54) **ELECTRONIC DEVICE, METHOD OF OPERATION AND COMPUTER PROGRAM**

(71) Applicant: Vestel Elektronik Sanayi ve Ticaret A.S., 45030 Manisa (TR)
(72) Inventor: ÇUBUKÇU, Baran, 45030 Manisa (TR)
(74) Representative: Whitfield, Ian

(57) **Abstract**

An electronic device (1) has an audio playback function. The electronic device (1) includes: a microphone (8) for receiving ambient noise of the electronic device (1); and a controller (7). The controller (7) is configured to: at a time when the electronic device (1) is activated, obtain a volume for audio playback by the electronic device (1), the volume being a function of at least the level of ambient noise of the electronic device (1); and set the volume of the electronic device (1) according to the obtained volume.

## Description

### Technical Field

The present disclosure relates to an electronic device, a method of operating an electronic device and a computer program.

### Background

Electronic devices, such as televisions, mobile phones, tablet computers etc., typically have an audio playback function and therefore include one or more speakers that can output the sound of media content, such as films/movies, television programmes, music etc. The volume of the audio playback output by the speakers (i.e. the loudness of the sound) can be increased or decreased by a user depending on the user's preference. For example, if the electronic device is a television and the user is watching a sports match or an action movie, the user may increase the volume. On the other hand, if the electronic device is a television and the user is watching media content at night, the user may decrease the volume.

### Summary

According to a first aspect disclosed herein, there is provided an electronic device having an audio playback function, the electronic device comprising: a microphone for receiving ambient noise of the electronic device; and a controller configured to: at a time when the electronic device is activated, obtain a volume for playback by the electronic device, the volume being a function of at least the level of ambient noise of the electronic device; and set the volume of the electronic device according to the obtained volume.

This allows the controller to automatically set the volume of the sound output by the electronic device when it is activated to a level that takes into account the ambient noise of the electronic device. For example, if the level of ambient noise of the electronic device is high then the controller may set the volume for playback by the electronic to be high, and if the ambient noise of the electronic device is low then the controller may set the volume for playback by the electronic device to be low.. This provides an improved user experience and reduces the user's frustration in certain situations such as when the electronic device is activated in a particularly noisy environment.

In an example, the volume for the electronic device is a function of the level of ambient noise of the electronic device and the time of day when the electronic device is activated.

In an example, the controller is configured to: record a profile of use of the electronic device, the profile including, for each of a number of time intervals, a plurality of audio playback volumes selected by a user and associated ambient noise levels; and obtain the volume for the electronic device from the profile.

In an example, a recorded audio playback volume for a time interval is an average volume for audio playback for the time interval based on historical data.

In an example, the controller is configured to: set an initial volume for the electronic device which is less than or equal to the obtained volume; and increase the volume of the electronic device from the initial volume to the obtained volume.

In an example, the controller is configured to obtain a measure of the ambient noise of the electronic device at a time when the electronic device is activated.

In an example, the controller is configured to obtain a measure of the ambient noise of the electronic device by subtracting the sound output by the electronic device from the sound received by the microphone

In an example, the electronic device comprises a data storage.

According to a second aspect disclosed herein, there is provided a method of operating an electronic device having an audio playback function, the method comprising: obtaining, at a time when the electronic device is activated, a volume for playback by the electronic device, the volume being a function of at least the level of ambient noise of the electronic device; and setting the volume of the electronic device according to the obtained volume.

In an example, the volume for the electronic device is a function of the level of ambient noise of the electronic device and the time of day the electronic device is activated.

In an example, the method comprises: recording a profile of use of the electronic device, the profile including, for each of a number of time intervals, a plurality of audio playback volumes selected by a user and associated ambient noise levels; and obtaining the volume for the electronic device from the profile.

In an example, a recorded audio playback volume for a time interval is an average volume for audio playback for the time interval based on historical data.

In an example, the method comprises: setting an initial volume for the electronic device which is less than or equal to the obtained volume; and increasing the volume of the electronic device from the initial volume to the obtained volume.

In an example, the measure of the ambient noise of the electronic device is obtained at a time when the electronic device is activated.

In an example, the measure of the ambient noise of the electronic device is obtained by subtracting the sound output by the electronic device from sound received by the microphone.

According to a third aspect disclosed herein, there is provided a computer program comprising instructions such that when the computer program is executed on an electronic device having an audio playback function, the electronic device is arranged to: obtain, at a time when the electronic device is activated, a volume for playback by the electronic device, the volume being a function of at least the level of ambient noise of the electronic device; and set the volume of the electronic device according to the obtained volume.

### Brief Description of the Drawings

To assist understanding of the present disclosure and to show how embodiments may be put into effect, reference is made by way of example to the accompanying drawings in which:
Figure 1 shows schematically an elevation view of an example of an electronic device;
Figure 2 shows an example of a table stored in a data storage of the electronic device shown in Figure 1;
Figure 3 shows an example of a populated table stored in a data storage of the electronic device shown in Figure 1; and
Figure 4 shows an example of a method of operation of the electronic device shown in Figure 1.

### Detailed Description

Electronic devices, such as televisions, mobile phones, computers, etc., typically have an audio playback function and therefore include or are connected to one or more speakers that can output the sound of media content, such as films/movies, television programmes, music, etc. The volume of the audio playback output by the speakers (i.e. the loudness of the sound) can be increased or decreased by a user depending on the user's preference. For example, if the electronic device is a television and the user is watching a sports match or an action movie, the user may increase the volume. If the electronic device is a television and the user is watching media content at night, the user may decrease the volume.

When a user activates an electronic device to play back media (by for example turning on or waking up a television, activating a media player on a computer, etc.), the volume (i.e. loudness) is typically initially set automatically to the volume that was last set by a user before the electronic device was last deactivated. This can be problematic in certain situations when the volume of the electronic device before it was deactivated is very different from the volume now desired by a user when the electronic device is activated. For example, if a user activates the electronic device at time when there is little ambient noise (e.g. night time) after having previously set the volume of the electronic device to be very loud because they were watching/listening at a time when there was more ambient noise (e.g. the evening), the loudness of the sound output by the electronic device may disturb or wake up the user's family and/or neighbours. At best, this contrast between the previously set volume and the user's desired volume is inconvenient.

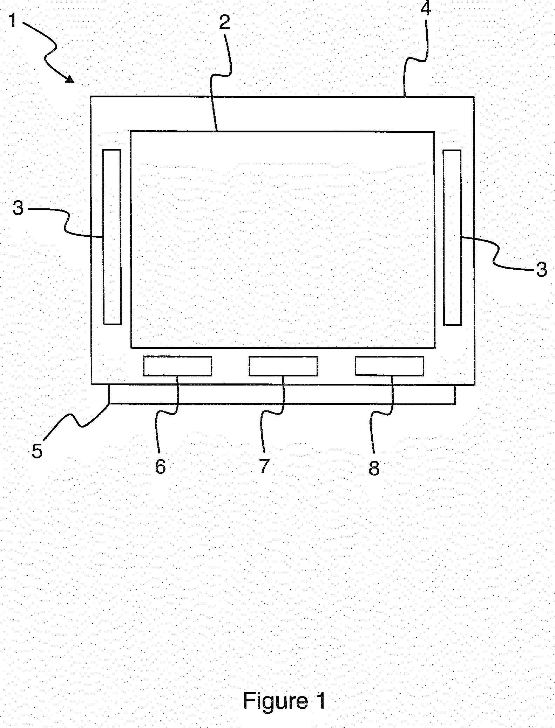

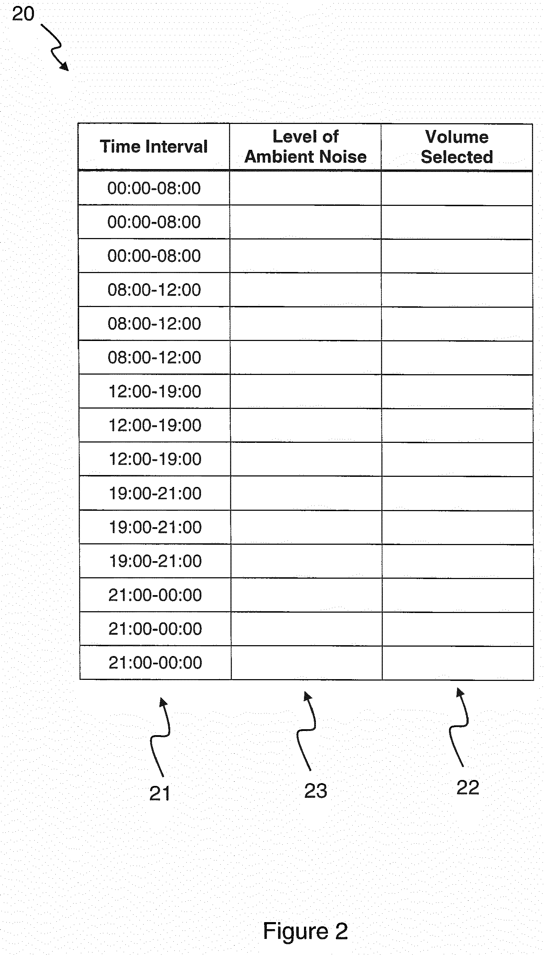

Referring now to Figures 1 and 2, there is shown schematically an example of an electronic device 1 including a display 2 and two loudspeakers 3. The display 2 and the speakers 3 are held within a housing 4. The housing 4 is supported off the ground by a base 5. In this example, the electronic device 1 is a television. In another example, the electronic device 1 is another device that has an audio playback/output function. For example, the electronic device 1 may be a mobile phone (e.g. a smart phone or the like), a computer such as a personal computer, laptop or tablet with media player software, some other computer visual display unit, a radio, CD, MP3 or other hardware media player, etc.

The speakers 3 output sound corresponding to media content being output by the electronic device 1. The volume (i.e. the loudness) of the sound output by the speakers 3 is adjustable. The speakers 3 may be for example dynamic speakers.

The base 5 provides for a connection (not shown) to a source of electricity, such as a mains electricity connection. The electronic device 1 also includes a power button (not shown) for activating and deactivating the electronic device 1.

The electronic device 1 also includes a data storage 6, a controller 7 and a microphone 8.

The data storage 6 stores information on one or more profiles, which will be discussed further below.

The controller 7, which may be a processor or the like, is provided within the housing 4 for controlling the operation of the electronic device 1. The controller 7 is connected to the speakers 3, the data storage 6 and the microphone 8.

The controller 7 sets the volume of the electronic device 1 at the time when the electronic device 1 is activated to allow for the ambient noise of the electronic device 1 at the time of activation. In an example, the controller 7 is configured to obtain a measure of the ambient noise of the electronic device 1 from the microphone 8 at the time of activation of the device 1 and then obtain a volume for the electronic device 1 based on the measure of ambient noise.

In an example, the controller 7 records a profile of volumes set for the electronic device 1 during use so that the volume of the electronic device 1 when it is activated can be set in accordance with the user's preferred volume, whilst still taking into account the ambient noise of the electronic device 1. The controller 7 is configured to record a profile 20 of use of the electronic device 1 and store the profile 20 in the data storage 6. Figure 2 shows an example of an unpopulated profile 20 (the controller 7 has not yet recorded any data in the table). In this example, the profile 20 can contain a plurality of average audio playback volumes 22 selected by the user for a number of different time intervals 21. The profile 20 can also contain a plurality of ambient noise levels 23 of the electronic device 1 associated with the same time intervals 21. The controller 7 may record data for the user profile 20 periodically during use of the electronic device 1. For example, the controller 7 may record data for the user profile 20 after every hour of consecutive use.

In this example, the controller 7 is configured to wait for a time period after the electronic device 1 has been activated before recording the volume for audio playback which was selected by a user. This provides a period of time for the user to adjust the volume of the electronic device 1 to a preferred level so that the controller 7 records the user's actual preferred volume. In one example, the period of time is ten seconds.

The controller 7 is configured to record a measure of the ambient noise of the electronic device 1, which is received by the microphone 8. In order to record a measure of the true ambient noise of the electronic device 1, the controller 7 may for example either record the ambient noise whilst no sound is being output from the speakers 3 or may compensate for the sound being output from the speakers 3 because this, or at least a portion of it, will be received by the microphone 8 and will thus affect the measure of the ambient noise recorded.

In this example, the controller 7 is configured to record the volume of noise received by the microphone 8 before any sound is output by the speakers 3 (e.g. as soon as the electronic device 1 has been activated). The controller 7 therefore assumes that any noise received by the microphone 8 whilst no sound is being output by the speaker 3 is ambient noise of the electronic device 1. In another example, the controller 7 is configured to record the volume of noise received by the microphone 8 whilst the speakers 3 are outputting sound having a low or very low volume. In this way, the noise received by the microphone 8 includes minimal or no sound output by the speakers 3. The controller 7 therefore assumes that the noise received by microphone 8 is (approximately) equal to the level of ambient noise of the electronic device 1.

In another example, the controller 7 is configured to record the volume of the noise received by the microphone 8 whilst the speakers 3 are outputting sound. To then obtain a measure of the ambient noise of the electronic device 1, the controller 7 must separate the ambient noise from the sound that is being output by the speakers 3. In an example, given that the controller 7 knows the characteristics of the sound being output by the speakers 3 (because for example the controller 7 controls the outputting of sound or is in communication with an audio processor of the device 1), the controller 7 can effectively subtract the sound output by the speakers 3 from the sound received by the microphone 8 to obtain the ambient noise. In another example, the controller 7 obtains a measure of the ambient noise of the electronic device 1 by filtering the sound received by the microphone 8 to select particular frequencies of the noise that correspond to typical ambient noise.

Referring further to Figure 2, in this example, there are five different non-equal time intervals 21. In another example, there may be more time intervals so as to improve the accuracy of the profile. In another example, there may be fewer time intervals so as to reduce to space used in the data storage 6. In another example, the time intervals may be equal.

In this example, the average volume is the average volume selected by a user within a particular time interval on a particular day. In another example, the average volume is the average volume selected by a user within a particular time interval over a number of days.

In this example, each level of ambient noise recorded in the profile 20 is an arbitrary noise level for a particular time interval over a number of days. In another example, each level of ambient noise recorded in the profile 20 is the average of the actual level of ambient noise within a particular time interval over a number of days.

In an example, the profile 20 is continually updated by the controller 7 as the user uses the electronic device 1. This ensures that the profile 20 maintains an accurate record of the user's preferred volumes in certain situations. In an example, the controller 7 is also configured so that the user can delete a profile 20 from the data storage 6. This allows a user to delete profiles that are no longer needed by the user. In an example, the controller 7 is also configured so that a user can delete the data in a profile 20 (i.e. reset the profile). In an example, the controller 7 is also configured so that the user can edit the data in a profile 20.

The controller 7 is configured to obtain a volume for the electronic device 1 from the profile 20 when the electronic device 1 is activated (by for example turning on or waking up the electronic device 1, activating a media player on the electronic device 1, etc.). In particular, the controller 7 is configured to obtain a volume for the electronic device 1 based on the current time and a measure of the current ambient noise of the electronic device 1. The controller 7 is also configured to set the volume of the electronic device 1 in accordance with the obtained volume from the profile 20. The controller 7 therefore sets the start-up volume of the electronic device 1 to be a level that is preferred by a user given the time of day of activation of the device 1 and the current ambient noise level in this example.

In an example, the controller 7 is also configured to initially set the volume of the electronic device 1 to be the lowest volume in the profile 20 that corresponds to the time of day that the electronic device 1 is activated. This ensures that the volume of the electronic device 1 set by the controller 7 when it is activated is not overly loud. The volume set by the controller 7 may be too quiet, but this is typically not disruptive for the user. The controller 7 is also configured to then increase the volume of the electronic device 1 to a user's preferred level in accordance with the measure of ambient noise of the electronic device 1 obtained by the microphone 8, if required. In an example, the controller 7 is configured so that this increase in the volume of the electronic device 1 in accordance with the ambient noise can be cancelled by a user. The user may cancel the volume increase by for example pressing a button (such as a volume control button) on a remote control for the electronic device 1.

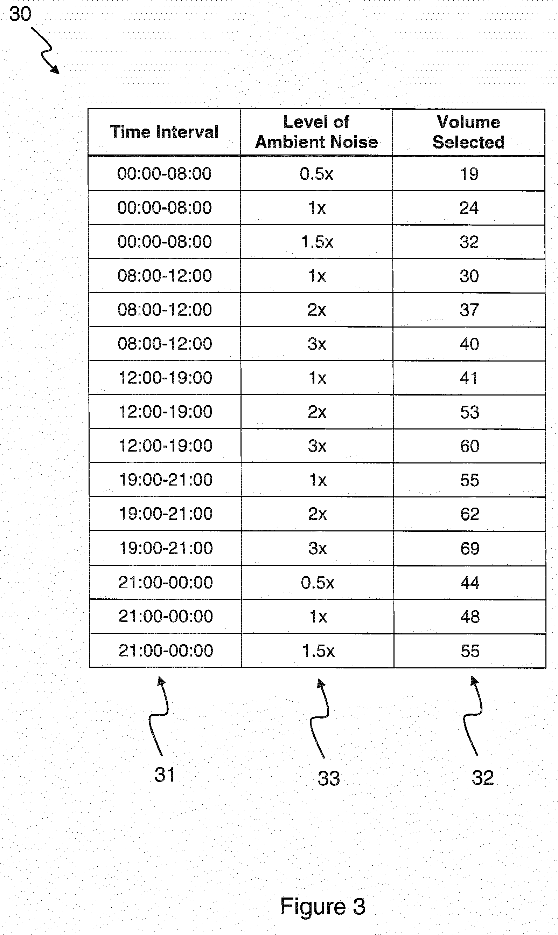

Figure 3 shows an example of a table including a profile 30 that has been recorded by the controller 7. The profile 30 includes the average volume levels 32 of the electronic device 1 selected by a user during the specified time intervals 31 and the average level of ambient noise 33 during the same time intervals 31. The user can select a volume of between 1 and 100, with 0 being no sound output (i.e. mute) and 100 being the maximum loudness that can be output by the electronic device 1. The volume is selectable in intervals of 1. The level of ambient noise indicated in this example is in arbitrary units and the recorded levels of ambient noise shown are relative to one another.

As is shown in Figure 3, the volume selected by the user is higher when the ambient noise of the electronic device 1 is relatively high, and lower when the ambient noise of the electronic device 1 is relatively low.

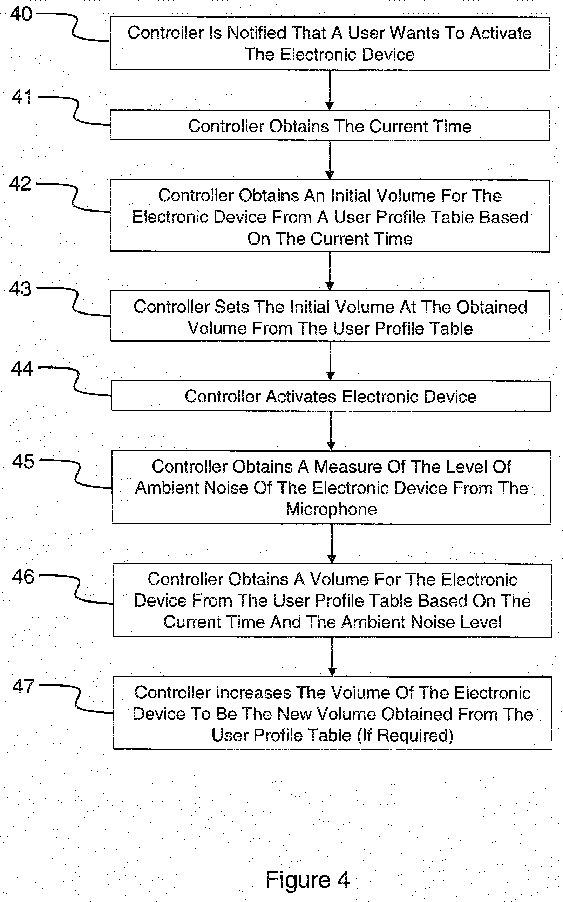

An example of a method of the controller 7 setting a volume for playback by the electronic device 1 at a time when the electronic device 1 is activated is shown in Figure 4.

Initially, the electronic device 1 shown in Figure 1 is in a deactivated state. However, the electronic device 1 has been previously used by a user and so the controller 7 has recorded a profile 30 for the user. An example of a populated profile is shown in Figure 3. As described above, the profile 30 includes the average volume levels 32 of the electronic device 1 selected by the user during specified time intervals 31 and the average level of ambient noise 33 measured during the same time intervals 31.

At 40, the user, wanting to activate the electronic device 1, presses a power button located on the electronic device 1. The controller 7 detects that the power button has been pressed and that the electronic device 1 is to be activated.

At 41, in response to the user pressing the power button, the controller 7 obtains the current time. In this example, the controller 7 obtains a time of 20:03.

At 42, the controller 7 then obtains an initial volume for playback by the electronic device 1 from the profile 30. The initial volume is a function of the current time. In particular, the initial volume obtained by the controller 7 is the lowest of the average volumes for the particular time interval corresponding to the current time. Accordingly, in this example, since the current time is 20:03, the controller obtains an initial volume of 55 from the profile 30.

At 43, the controller 7 then sets the initial volume for playback by the electronic device 1 to be the volume obtained from the profile 30. Therefore, in this example, the controller 7 sets the initial volume for playback by the electronic device to be 55. The volume of the electronic device 1 is now a function of the user's preferred volume level for the current time of day.

At 44, after having set the initial volume for playback by the electronic device 1, the controller 7 then activates the electronic device 1 from its deactivated state.

At 45, before any sound has been output from the speaker 3 by the electronic device 1, the controller 7 obtains a measure of the level of ambient noise of the electronic device 1 by obtaining a measure of the sound received by the microphone 8. In this example, the controller 7 obtains a level of ambient noise of 2x.

At 46, the controller 7 obtains a new volume for the electronic device 1 from the profile 30. The new volume is a function of both the measure of the ambient noise of the electronic device 1 and the current time. In this example, since the current time is 20.03 and the measure of ambient noise is 2x, the controller 7 obtains a new volume of 62 from the profile 30.

At 47, the controller 7 increases the volume for playback by the electronic device 1 from the previously set initial volume to the newly obtained volume (if required). Therefore, in this example, the controller 7 increases the volume of the electronic device 1 from 55 to 62. The volume for playback by the electronic device 1 is now a function of the user's preferred volume level for the current time of day and for the current level of ambient noise of the electronic device 1. In some examples, the newly obtained volume may be the same as the initial volume and therefore the controller 7 is not required to increase the volume of the electronic device 1.

An advantage of this arrangement is that the controller can set the initial volume of the sound output by the electronic device at a time when it is first activated to a level that is approximately an average of the user's preferred volume level for the current time. The controller can then increase the volume of the sound output to a level that is approximately an average of the user's preferred volume level for the current time but now also taking into account the current level of ambient noise of the electronic device. This means that the volume of the electronic device at a time when it is activated by a user is not overly loud or too quiet and is instead at a level that the user prefers, which provides an improved user experience, reduces the user's frustrations and avoids disturbing any sleeping neighbours and/or family members.

Although at least some aspects of the examples described herein with reference to the drawings comprise methods performed in the controller/processor 7, the invention also extends to computer programs, particularly computer programs on or in a carrier or computing device, adapted for putting the invention into practice. The program may be in the form of non-transitory source code, object code, a code intermediate source and object code such as in partially compiled form, or in any other non-transitory form suitable for use in the implementation of processes according to the invention. The carrier may be any entity or device capable of carrying the program. For example, the carrier may comprise a storage medium (e.g. the data storage 6), such as a solid-state drive (SSD) or other semiconductor-based RAM; a ROM, for example a CD ROM or a semiconductor ROM; a magnetic recording medium, for example a floppy disk or hard disk; optical memory devices in general; etc.

It will be understood that the controller/processor 7 referred to herein may in practice be provided by a single chip or integrated circuit or plural chips or integrated circuits, optionally provided as a chipset, an application-specific integrated circuit (ASIC), field-programmable gate array (FPGA), digital signal processor (DSP), graphics processing units (GPUs), etc. The chip or chips may comprise circuitry (as well as possibly firmware) for embodying at least one or more of a data processor or processors and a digital signal processor or processors, which are configurable so as to operate in accordance with the exemplary embodiments.

Reference is made herein to data storage for storing data. This may be provided by a single device or by plural devices. Suitable devices include for example a hard disk and non-volatile semiconductor memory.

The example described herein are to be understood as illustrative examples of embodiments of the invention. Further embodiments and examples are envisaged. Any feature described in relation to any one example or embodiment may be used alone or in combination with other features. In addition, any feature described in relation to any one example or embodiment may also be used in combination with one or more features of any other of the examples or embodiments, or any combination of any other of the examples or embodiments. Furthermore, equivalents and modifications not described herein may also be employed within the scope of the invention, which is defined in the claims.

## Claims

1. An electronic device having an audio playback function, the electronic device comprising:
a microphone for receiving ambient noise of the electronic device; and
a controller configured to: at the time when the electronic device is activated, obtain a volume for playback by the electronic device, the volume being a function of at least the level of ambient noise of the electronic device; and set the volume of the electronic device according to the obtained volume.

2. An electronic device according to claim 1, wherein the volume for the electronic device is a function of the level of ambient noise of the electronic device and the time of day when the electronic device is activated.

3. An electronic device according to claim 1 or claim 2, wherein the controller is configured to: record a profile of use of the electronic device, the profile including, for each of a number of time intervals, a plurality of audio playback volumes selected by a user and associated ambient noise levels; and obtain the volume for the electronic device from the profile.

4. An electronic device according to claim 3, wherein a recorded audio playback volume for a time interval is an average volume for audio playback for the time interval based on historical data.

5. An electronic device according to any preceding claim, wherein the controller is configured to: set an initial volume for the electronic device which is less than or equal to the obtained volume; and increase the volume of the electronic device from the initial volume to the obtained volume.

6. An electronic device according to any preceding claim, wherein the controller is configured to obtain a measure of the ambient noise of the electronic device at the time when the electronic device is activated.

7. An electronic device according to any preceding claim, wherein the controller is configured to obtain a measure of the ambient noise of the electronic device by subtracting the sound output by the electronic device from sound received by the microphone.

8. A method of operating an electronic device having an audio playback function, the method comprising:
obtaining, at a time when the electronic device is activated, a volume for audio playback by the electronic device, the volume being a function of at least the level of ambient noise of the electronic device; and
setting the volume of the electronic device according to the obtained volume.

9. A method according to claim 8, wherein the volume for the electronic device is a function of the level of ambient noise of the electronic device and the time of day when the electronic device is activated.

10. A method according to claim 8 or claim 9, comprising:
recording a profile of use of the electronic device, the profile including, for each of a number of time intervals, a plurality of audio playback volumes selected by a user and associated ambient noise levels; and
obtaining the volume for the electronic device from the profile.

11. A method according to claim 10, wherein a recorded audio playback volume for a time interval is an average volume for audio playback for the time interval based on historical data.

12. A method according to any one of claims 8 to 11, comprising:
setting an initial volume for the electronic device which is less than or equal to the obtained volume; and
increasing the volume of the electronic device from the initial volume to the obtained volume.

13. A method according to any one of claims 8 to 12, wherein the measure of the ambient noise of the electronic device is obtained at the time when the electronic device is activated.

14. A method according to any one of claims 8 to 13, wherein the measure of the ambient noise of the electronic device is obtained by subtracting the sound output by the electronic device from sound received by the microphone.

15. A computer program comprising instructions such that when the computer program is executed on an electronic device having an audio playback function, the electronic device is arranged to:
obtain, at a time when the electronic device is activated, a volume for audio playback by the electronic device, the volume being a function of at least the level of ambient noise of the electronic device; and
set the volume of the electronic device according to the obtained volume.
